Europäisches Patentamt

European Patent Office

Office européen des brevets

(19)

(11) Numéro de publication: **0 046 105**
**B1**

(12) **FASCICULE DE BREVET EUROPEEN**

(45) Date de publication du fascicule du brevet: **02.05.85**

(51) Int. Cl.⁴: **G 06 F 15/336**

(21) Numéro de dépôt: **81401222.5**

(22) Date de dépôt: **29.07.81**

(54) **Dispositif opérateur numérique rapide.**

(30) Priorité: **06.08.80 FR 8017360**

(43) Date de publication de la demande:
**17.02.82 Bulletin 82/07**

(45) Mention de la délivrance du brevet:
**02.05.85 Bulletin 85/18**

(84) Etats contractants désignés:
**AT BE CH DE GB IT LI LU NL SE**

(56) Documents cités:
**FR-A-2 417 806**

**MITTEILUNGEN AGEN; Nov. 1979; DAZIO ET AL; "DER SIGNALISIERUNGSTEIL EINES DIGITALEN TRANSMULTIPLEXERS", pages 11-20**

(73) Titulaire: **THOMSON-CSF TELEPHONE
146, Boulevard de Valmy
F-92707 Colombes (FR)**

(72) Inventeur: **Houdard, Jean-Pierre
THOMSON-CSF-SCPI 173 bld. Haussmann
F-75360 Paris Cedex 08 (FR)**
Inventeur: **Chaverneff, Vladimir
THOMSON-CSF-SCPI 173 bld. Haussmann
F-75360 Paris Cedex 08 (FR)**

(74) Mandataire: **Weinmiller, Jürgen et al
Zeppelinstrasse 63
D-8000 München 80 (DE)**

Courier Press, Leamington Spa, England.

## Description

La présente invention se rapporte à un dispositif opérateur numérique rapide.

On connaît d'après l'article des pages 11 à 20 de la revue suisse "Mitteilungen AGEN" de novembre 1979, et en particulier d'après la figure 18 de la page 19, un convoleur pour filtres numériques comprenant une mémoire morte dont les différentes entrées sont reliées chacune à la sortie série d'un registre à décalage dans lequel progressent les éléments binaires de chacun des nombres à multiplier par des coefficients fixes. Un tel convoleur est généralement plus rapide que les convoleurs conventionnels, mais dans certains cas, sa vitesse de traitement n'est pas suffisante, en particulier lorsque le filtre dans lequel il est disposé doit fonctionner en temps partagé sur trente-deux voies par exemple, et/ou que ce filtre doit avoir des performances très élevées, donc doit être d'ordre élevée, c'est-à-dire que les valeurs sur lesquelles porte la convolution comportent un grand nombre d'éléments binaires.

On connaît d'après le document FR—A— 2 417 806 un convoleur comportant une mémoire morte dans laquelle sont enregistrées diverses valeurs de combinaisons de coefficients, cette mémoire morte coopérant avec des moyens l'adressant avec les poids de même rang des multiplicateurs, et sa sortie étant reliée à un accumulateur. Ce convoleur ne permet pas d'effecteur des opérations sur des multiplicateurs très longs, de par exemple plusieurs dizaines ou centaines d'éléments binaires, puisque les mémoires mortes connues ont une capacité limitée à une douzaine d'entrées d'adressage.

La présente invention a pour objet un dispositif opérateur numérique rapide, en particulier un convolueur qui soit plus rapide que le convolueur connu.

Le dispositif opérateur numérique rapide de l'invention est destiné à effectuer une opération sur au moins deux termes, et comporte plusieurs mémoires de mémorisation de combinaisons d'un terme opératoire, et selon l'invention il comporte, à la sortie d'un premier étage de registres d'entrée sur lesquels se présentent simultanément en parallèle tous les éléments binaires d'un premier terme de l'opération à effectuer, le premier terme étant un ensemble de $n$ ($n \geq 1$) suites d'éléments binaires pondérés de poids 0 à $(m-1)$ représentant chacune une valeur discrète, un étage de traitement opératoire comportant plusieurs groupes de mémoires comportant chacun une ou plusieurs mémoires, dans chacun desquels sont mémorisées, de façon connue en soi, toutes les combinaisons opératoires du second terme de l'opération à effectuer, les entrées de chaque groupe de mémoires étant reliées aux sorties de tous les registres d'entrée auxquelles apparaissent les éléments binaires d'un même poids donné, l'étage de traitement opératoire étant suivi d'un second étage de registres à entrées et sorties parallèles, ces registres étant répartis en groupes correspondant aux groupes de mémoires, les entrées de ces registres étant reliées aux sorties des mémoires de leur groupe, et leurs sorties étant pondérées, c'est-à-dire que leut poids propre est augmenté du poids des éléments binaires dur premier terme que reçoit leur groupe, les sorties des registres de ce second étage étant reliées à un premier étage de sommation pondérée comportant un étage de blocs de détermination de nombre de "1" et un troisième étage de registres, les blocs étant affectés chacun d'un poids binaire depuis le poids zéro jusqu'à un poids maximal égal au poids maximal des sorties pondérées des registres du second étage de registres, les entrées de chaque bloc de poids donné étant reliées à toutes les sorties de même poids des registres du second étage de registres, les registres du troisième étage de registres étant affectés chacun à un bloc de détermination, et leurs sorties étant pondérées, c'est-à-dire que leur poids propre est augmenté du poids du bloc correspondant, ce premiet étage de sommation pondérée étant suivi d'un ou de plusieurs autres étages de sommation pondérée similaires, dont les liaisons sont effectuées de manière similaire, le nombre de ces étages de sommation pondérée étant tel que dans le dernier d'entre eux chaque bloc de détermination a au maximum deux sorties, les sorties des registres de ce dernier étage de sommation pondérée étant reliées à des entrées correspondantes d'un additionneur rapide.

Selon une réalisation de l'invention, les mémoires de l'étage de traitement opératoire sont soit des mémoires mortes, soit des mémoires vives. Selon une variante, les mémoires peuvent être constituées par plusieurs ensembles commutables de mémoires mortes.

Lorsque l'opération à effectuer est une convolutioon, on mémorise dans chaque groupe de mémoires les différentes combinaisons possibles de sommation de coefficients.

La présente invention sera mieux comprise à l'aide de la description détaillée d'un mode de réalisation pris comme exemple non limitatif et illustré par le dessin annexé, sur lequel:

— la figure 1 est un schéma simplifié d'un convolueur conforme à la présente invention, et
— la figure 2 est un schéma d'un bloc de détermination de nombre de "1" pouvant être utilisé dans le convolueur de la figure 1.

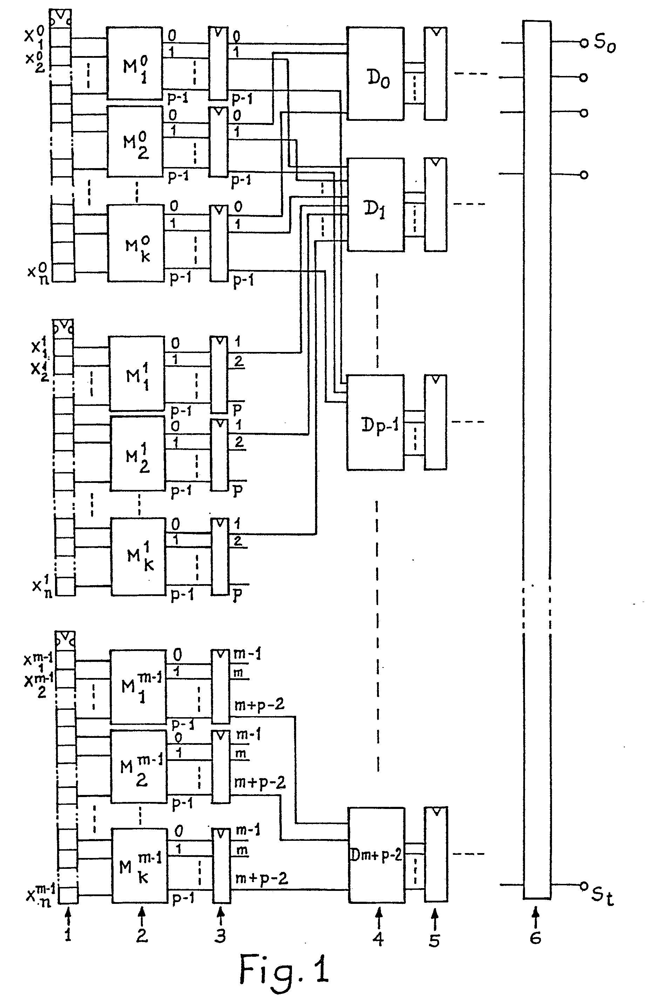

On a représenté sur la figure 1 un convolueur pour filtre numérique, mais il est bien entendu que l'invention se rapporte à différents opérateurs numériques tels que des additionneurs, des multiplieurs, etc., permettant d'exécuter des opérations mathématiques sur au moins deux termes disponibles sous forme numérique. Dans le cas d'une convolution, le premier terme se compose d'une suite de $n$ valeurs discrètes retardées que l'on note $X_1$, $X_2$, $X_3$ ... $X_n$ et le second terme se compose d'une suite de $n$ coefficients correspondants que l'on note: $A_1$, $A_2$,

$A_3 \dots A_n$. Ces coefficients peuvent être soit fixes dans le cas de filtres numériques classiques, soit variables dans le cas de filtres numériques adaptatifs tels que des annuleurs d'écho autoadaptatifs. Chacune des $n$ valeurs discrètes retardées $X_1$ à $X_n$ peut s'écrire:

$X_j = x_j^{m-1}, x_j^{m-2} \dots x_j^1 \, x_j^0$, $j$ étant le rang de la valeur discrète retardée considérée, et pouvant avoir toute valeur de 1 à $n$. Les valeurs $x_j^0$ à $x_j^{m-1}$ sont les $m$ éléments binaires de poids 0 à m$-$1 de la valeur discrète retardée $X_j$.

De même, chacun des $n$ coefficients A peut s'écrire:

$A_j = a_j^{p-1} a_j^{p-2} \dots a_j^1 a_j^0$, et comporte $p$ éléments binaires, $p$ pouvant être différent de $m$.

Dans le mode de réalisation décrit ci-dessous, on suppose que l'on peut disposer simultanément de toutes les valeurs discrètes retardées nécessaires à la convolution. On regroupe par poids tous les éléments binaires de ces valeurs discrètes retardées et on les introduit dans un étage 1 de $m$ registres. Ces registres peuvent aussi bien être les registres de sortie des circuits fournissant les valeurs discrètes retardées que des registres séparés. Pour la commodité du dessin, on a représenté un registre à $n$ cellules pour chaque poids d'éléments binaires des valeurs discrètes retardées, les registres étant disposés, de haut en bas, suivant les poids croissants de ces éléments binaires, depuis le poids 0 jusqu'au poids m$-$1. Toutefois il est bien entendu que dans le cas où l'on doit traiter un grand nombre de valeurs discrètes retardées, plusieurs registres peuvent être utilisés pour chaque poids.

L'étage 1 de registres est suivi d'un étage 2 de traitement opératoire comportant $m$ groupes de $k$ mémoires chacun, chacun de ces groupes étant affecté à un poids d'éléments binaires. Ces mémoires sont référencées $M_1^0$ à $M_k^0$ pour le poids zéro, et ainsi de suite jusqu'au poids m$-$1 dont les mémoires sont référencées $M_1^{m-1}$ à $M_k^{m-1}$. Pour chaque poids d'éléments binaires, la sortie de chacune des cellules des registres de l'étage 1 est reliée à une entrée d'adressage correspondante de l'une des mémoires de son groupe. Toutefois, chaque groupe peut ne comporter qu'une seule mémoire si la capacité de celli-ci est suffisante. Pour simplifier les explications, on suppose que toutes les mémoires de l'étage 2 sont identiques. Si certaines d'entre elles étaient de capacité différente, leurs sorties seraient reliées de façon évidente pour l'homme de l'art à la lecture de la description ci-dessous.

Chacune des mémoires de l'étage 2 comporte $p$ sorties de poids intrinsèque 0 à p$-$1. Chacune de $p$ sorties des mémoires de l'étage 2 est reliée à l'entrée d'une cellule d'un registre faisant partie d'un étage de registres 3. Pour la commodité du dessin, on a affecté un registre de l'étage 3 à chacune des mémoires de l'étage 2, mais il est possible de grouper différemment ces registres.

Les sorties des différentes cellules des registres de l'étage 3, sont pondérées de la façon suivante. On ajoute au poids intrinsèque des différentes sorties correspondantes des mémoires de l'étage 2 un poids égal au poids des éléments binaires traités par ces mémoires.

Ainsi, les sorties des mémoires $M_1^0$ à $M_k^0$, traitant les éléments binaires de poids zéro ne donnent lieu à aucun changement de poids, mais les sorties des autres mémoires donnent lieu à un tel changement. Par exemple, les sorties des registres de l'étage 3 reliées aux sorties des mémoires $M_1^1$ à $M_k^1$ (ayant toujours des poids intrinsègues 0 à p$-$1 respectivement) ont pour poids, après pondération, 1 à $p$ respectivement. Cette pondération se fait de façon analogue pour tous les autres registres de l'étage 3, et les sorties de ceux reliés aux mémoires $M_1^{m-1}$ à $M_k^{m-1}$ ont pour poids, après pondération, (m$-$1) à (m+$-$2) respectivement.

L'étage 3 est suivi d'un étage 4 de sommation pondérée comportant (m+p$-$1) blocs de détermination de nombre de 1 respectivement référencés $D_0$ à $D_m$+p$-$2, dont chacun est affecté d'un poids propre, de 0 à (m+p$-$2) respectivement. Les entrées de chacun des blocs $D_0$ à $D_{m+p-2}$ sont reliées aux sorties de même poids des registres de l'étage 3. Par conséquent, et comme on peut le vérifier facilement, les blocs de l'étage 4 ont des nombres différents d'entrées utiles. Cependant, pour simplifier la réalisation, on peut utiliser des blocs dont certains ont un nombre d'entrées supérieur au nombre nécessaire (par exemple tous les blocs peuvent avoir m+p$-$2 entrées), ce qui réduit le nombre de modèles différents de blocs. Par exemple, on peut déterminer que les blocs $D_0$ et $D_{m+p-2}$ doivent avoir au moins $k$ entrées, que les blocs $D_1$ et $D_{m+p-1}$ doivent avoir 2k entrées, etc. Les blocs de détermination $D_0$ à $D_{m+p-2}$ sont des circuits, par exemple des mémoires mortes ou des circuits PLA, fournissant chacun sur ses sorties la valeur, en binaire pur, du nombre de "1" présents sur ses entrées. Par conséquent, le nombre de sorties utiles de chacun de ces circuits est égal à la caractéristique, augmentée d'une unité, du logarithme base 2 du nombre de ses entrées utiles si ce nombre d'entrées n'est pas une puissance de 2, et est égal à la caractéristique du logarithme base 2 du nombre d'entrées si ce nombre d'entrées est une puissance de 2.

L'étage 4 est suivi d'un étage 5 de registres, un registre étant affecté à chaque bloc de l'étage 4 pour simplifier le dessin, chaque cellule d'un registre étant reliée à une sortie correspondante du bloc auquel est affecté ce registre. Les différentes sorties des registres de l'étage 5 sont pondérées de façon analogue à la façon dont sont pondérées les sorties des registres de l'étage 3.

L'ensemble d'étages de traitement 4 et 5 est suivi d'un ou de plusieurs ensembles similaires (non représentés). Le nombre de ces ensembles est déterminé de façon que chacun des blocs de détermination du dernier de ces ensembles ait au maximum deux sorties. Les sorties des cellules des registres de ce dernier ensemble sont reliées aux entrées d'un additionneur rapide 6 dont les

sorties $S_0$ à $S_t$ constituent les sorties du convolueur.

Dans chaque étage de registres, les entrées de signaux d'horloge sont toutes reliées ensemble et à une sortie correspondante d'un générateur approprié de signaux d'horloge (non représenté).

On remarquera que pour le poids le plus faible et pour le poids le plus élevé, et même pour d'autres poids plus faibles suivants, le nombre d'éléments binaires "1" est de un au maximum à partir d'un ensemble d'étages de traitement (tel que l'ensemble d'étages 4 et 5) donné, et bien entendu également pour tous les autres ensembles d'étages de traitement suivants. On peut alors supprimer les blocs de détermination de nombre de "1" correspondants et relier directement les cellules correspondantes des registres.

On peut facilement vérifier que même lorsque le nombre de valeurs discrètes retardées à traiter est très élevé (une ou plusieurs centaines par exemple) et que chacune d'elles comporte un grand nombre d'éléments binaires (plusieurs dizaines par exemple), le nombre d'ensembles d'étages de traitement est peu élevé. Par exemple, si on doit traiter 200 valeurs discrètes retardées comportant chacune 64 éléments binaires, et si les coefficients comportant également chacun 64 éléments binaires, les mémoires de l'étage 2 comportant chacune dix entrées d'adressage, il suffit de trois ensembles d'étages de traitement entre l'étage 3 et l'additionneur 6.

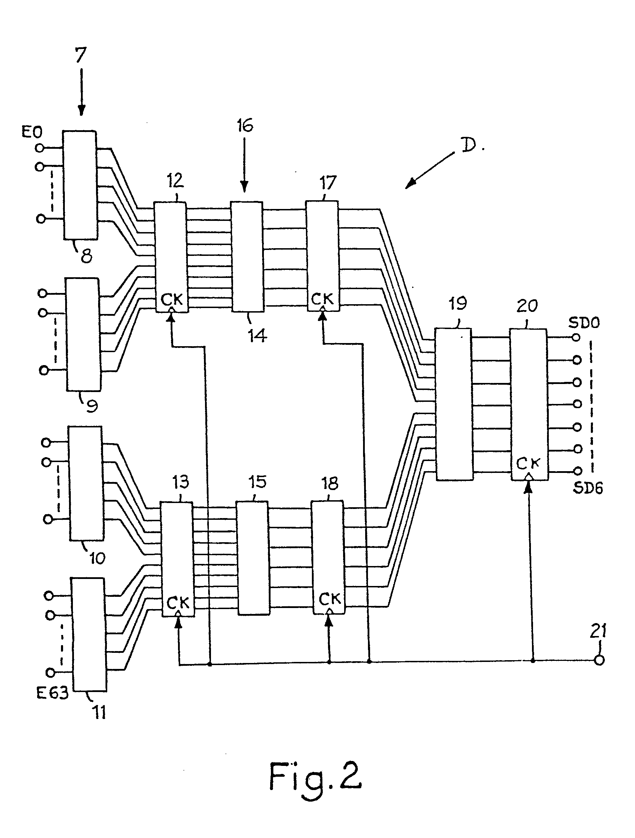

Le bloc D de détermination de nombre "1" représenté sur la figure 2 comporte 64 entrées respectivement référencées E0 à E63. Le bloc D comporte un premier étage de traitement 7 comprenant quatre circuits convertisseurs respectivement référencés 8, 9, 10 et 11. Les circuits convertisseurs 8 et 11 comportent chacun 16 entrées, et sont par exemple des circuits logiques connus sois la désignation PLA (Programmable Logic Array), c'est-à-dire des circuits logiques programmables. Les circuits logiques 8 à 11 sont réalisés, de façon connue en soi, pour présenter sur leurs sorties la valeur, en notation binaire pure, du total "1" présents sur toutes leurs entrées. Etant donné que chacun des circuits 8 à 11 comporte seize entrées, il y a au maximum seize "1" présents sur leurs entrées à un instant déterminé, et ces circuits doivent comporter cinq sorties chacun du fait qu'il faut cinq éléments binaires pour représenter tous les nombres de zéro à seize.

Les sorties des circuits convertisseurs 8 et 9 sont reliées à un registre 12 à dix cellules, et les sorties des circuits convertisseurs 10 et 11 sont reliées à des entrées correspondantes d'un registre 13 à dix cellules. Les dix sorties du registre 12 sont reliées à des entrées correspondantes d'un additionneur 14, tandis que les dix sorties du registre 13 sont reliées à des entrées correspondantes d'un autre additionneur 15, les additionneurs 14 et 15 formant un étage d'addition 16.

Etant donné que les additionneurs 14 et 15 sont reliés chacun à deux circuits convertisseurs de l'étage d'entrée 7, ils doivent pouvoir présenter chacun sur leurs sorties un nombre au plus égal à 32, c'est-à-dire un nombre représenté sur six éléments binaires signifcatifs au maximum. Les additionneurs 14 et 15 doivent donc comporter chacun six sorties. Les six sorties de l'additionneur 14 sont reliées à des entrées correspondantes d'un registre à bascules bistables 17, tandis que les six sorties de l'additionneur 15 sont reliées à des entrées correspondantes d'un registre à bascules bistables 18. Les six sorties de chacun des deux registres 17 et 18 sont reliées à des entrées correspondantes d'un additionner 19. Etant donné que l'additionneur 19 doit présenter sur ses sorties un nombre au plus égal à 64, c'est-à-dire le nombre maximal d'entrées du bloc D, cet additionner 19 doit comporter sept sorties. Les sept sorties de l'additionneur 19 sont reliées, par l'intermédiaire d'un registre à bascules bistables 20, à sept bornes de sorties respectivement référencées SD0 à SD6 formant les sept sorties du bloc D.

Les entrées CK de signaux d'horloge des registres 12, 13, 17, 18 et 20 sont toutes reliées à une borne commune 21 qui est elle-même reliée à un générateur de signaux d'horloge (non représenté).

Il est bien entendu que le bloc D représenté sur la figure 2 pourrait être comstitué différemment si l'on disposait d'autres circuits: en particulier si l'on disposait de circuits logiques programmables à 64 entrées, le circuit de la figure 2 se réduirait à un seul tel circuit dont les sept sorties seraient reliées directement, ou éventuellement par l'intermédiaire d'un registre, aux bornes S0 à S6, ce qui augmenterait bien entendu la rapidité de traitement du bloc D.

On va maintenant expliquer le fonctionnement du dispositif convolueur décrit ci-dessus.

Le fonctionnement des mémoires de l'étage opératoire 2 est connu en soi d'après le susdit article de "Mitteilungen AGEN". Dans chacune de ces mémoires (ou groupes de mémoires adressées en parallèle si le nombre d'éléments binaires par adresse n'est pas suffisant) on mémorise toutes les combinaisons possibles de sommation des coefficients correspondant aux valeurs discrètes arrivant sur les entrées d'adressage de la mémoire considérée. Si par exemple la mémoire $M_1^0$ a dix entrées d'adressage, elle est adressée par les éléments binaires $x_1^0$ à $x_{10}^0$, et on mémorise dans cette mémoire $M_1^0$ toutes les combinaisons possibles de sommation des coefficients $A_1$ à $A_{10}$, à savoir:

$$0, A_1, A_2 \ldots A_{10}, A_1+A_2, A_1+A_3 \ldots ,$$

$$A_2+A_3, A_2+A_4 \ldots A_1+A_2+A_3+A_4+$$

$$A_5+A_6+A_7+A_8+A_9+A_{10},$$

toutes ces combinaisons correspondant à toutes les configurations possibles de l'adressage de $M_1^0$ par l'ensemble des dix éléments binaires $x_1^0$ à

$x_{10}^0$. Si les mémoires $M_1^1$, $M_2^1$, ... $M_1^{m-1}$ ont la même capacité que la mémoire $M_1^0$, leur programmation est identique à celle de $M_1^0$, ce qui simplifie la réalisation du convolueur.

La convolution consiste à calculer $A_1 X_1 + A_n X_n + ... A_n x_n$. La conformation des étages 1 et 2 permet d'effectuer ce calcul de la façon équivalente suivante (en supposant que les mémoires ont dix entrées d'adressage, que m=24, et que n=50):

$$(A_1 x_1^0 + ... + A_{10} x_{10}^0) + (A_{11} x_{11}^0 + ... + A_{20} x_{20}^0) + \cdots$$

$$+ (A_{41} x_{41}^0 + ... A_{50} x_{50}^0) + (A_1 x_1^1 + ... + A_{10} x_{10}^1) +$$

$$(A_{11} x_{11}^1 + ... + A_{20} x_{20}^1) + ... + (A_{41} x_{41}^1 + ... + A_{50} x_{50}^1) + ...$$

$$+ (A_1 x_1^{23} + ... + A_{10} x_{10}^{23}) + ... + (A_{41} x_{41}^{23} + \cdots + A_{50} x_{50}^{23}).$$

A l'entrée de l'étage 4, les différents termes de cette somme sont regroupés par poids. L'ensemble d'étages de traitement 4, 15 et 5, ainsi que les ensembles d'étages de traitement simulaires suivants, et l'étage 6, permettant d'obtenir la valeur, en binaire, de cette somme de la façon expliquée ci-dessous à l'aide d'un exemple simplifié.

Soit à effectuer la somme de huit termes représentés sur seize éléments binaires chacun, et valent respectivement en notation décimale 35618, 18064, 00872, 06305, 00336, 02068, 05568, 08608. Dans le tableau 1 ci-après, ces huit termes ont été inscrits l'un au-dessous de l'autre, sur une rangée chacun, les éléments binaires de même poids figurant dans la même colonne. Au lieu d'inscrire à la dernière rangée de ce tableau, en notation binaire, la somme de ces huit termes, on inscrit, en notation décimale, le nombre de "1" figurant dans chaque colonne.

Bien entendu, on supose que les huit termes précités ont été obtenus à la sortie d'un étage de traitement opératoire tel que l'étage 2 du dessin. La somme de ces huit termes peut alors représenter le résultat d'une opération numérique, par exemple d'une convolution. Dans la suite des explications, on ne parlera que de la convolution mais il pourrait tout aussi bien s'agir d'une multiplication.

```
1 0 0 0 1 0 1 1 0 0 1 0 0 0 1 0

0 1 0 0 0 1 1 0 1 0 0 1 0 0 0 0

0 0 0 0 0 0 1 1 0 1 1 0 1 0 0 0

0 0 0 1 1 0 0 0 1 0 1 0 0 0 0 1

0 0 0 0 0 0 0 1 0 1 0 1 0 0 0 0

0 0 0 0 1 0 0 0 0 0 0 1 0 1 0 0

0 0 0 1 0 1 0 1 1 1 0 0 0 0 0 0

0 0 1 0 0 0 0 1 1 0 1 0 0 0 0 0
_____
1 1 1 2 3 2 3 5 4 3 4 3 1 1 1 1
```

On établit ensuite le tableau 2 ci-après en convertissant en notation binaire le nombre, exprimé ci-dessus en notation décimale, de "1" pour chaque colonne, et en pondérant chacun de ces nombres selon sa colonne, c'est-à-dire en affectant à chacun de ces nombres le poids de la colonne correspondante, la colonne la plus à troite ayant bien entendu le poids 0, qui est le poids de l'élément binaire le moins significatif des termes de la somme. On obtient ainsi le tableau 2 ci-dessous, en remarquant que le nombre le plus élevé de "1" est de cinq, c'est-à-dire qu'il suffit de trois éléments binaires au maximum pour représenter tous ces nombres de "1".

```
            TABLEAU 2
               001
               001
               001
               001
               011
               100
               011
               100
               101
               011
               010
               011
               010
               001
               001
               001
        _____
        001121222121111111
```

A la dernière rangée de ce tableau 3, on a reporté, en notation décimale, le nombre de "1" pour chaque colonne correspondante.

A partir du tableau 2, on recommence la pondération du résultat du comptage de "1" de chaque colonne, et l'on obtient alors le tableau 3 ci-dessous, dans lequel la première ligne L1 du résultat indique, en notation décimale, le nombre de "1" dans chaque colonne, et la deuxième ligne L2 est le résultat de l'addition de deux nombres binaires fictifs que l'on obtiendrait en disposant le tableau 3 sur deux lignes:

TABLEAU 3

```
                    01
                    01
                    01
                    01
                    01
                    01
                    01
                    10
                    01
                    10
                    10
                    10
                    01
                    10
                    01
                    01
```

L1:     01202110201111111
L2:     10010111001111111

On constate que le résultat d'addition figurant à la dernière ligne du tableau 4 est égal au résultat de la convolution, à savoir 77439 en notation décimale. En partant du tableau 3, on peut recommencer la pondération du nombre de "1" et l'on obtient le tableau 4 ci-après dans lequel on a directement reporté sur la ligne du résultat le résultat, en notation binaire, de l'addition, colonne par colonne, des éléments binaires.

TABLEAU 4

```
                    01
                    01
                    01
                    01
                    01
                    01
                    01
                    00
                    10
                    00
                    01
                    01
                    10
                    00
                    10
                    01
```

10010111001111111

On constate que le résultat d'addition du tableau 4 est aussi égal au résultat de la convolution. Par conséquent, on peut obtenir le résultat de la convolution d'après l'un quelconque des tableaux 1 à 4. En pratique, il est préférable de se servir du tableau 3, dans lequel chaque colonne comporte au maximum deux éléments binaires "1". Le résultat de la convolution est alors obtenu par un additionneur binaire classique, de préférence un additionneur binaire rapide, qui est l'additionneur 6 de la figure 1.

Les tableaux 3 et 4 montrent que par une suite de pondérations et de comtages d'éléments binaires colonne par colonne, on arrive à obtenir un tableau dans lequel chaque colonne ne comporte plus qu'un seul élément binaire "1", il n'y a alors même plus à utiliser d'additionneur, mais à détecter la présence ou l'absence d'un élément binaire "1". Toutefois, on remarquera que l'exemple décrit ci-dessus se rapporte à des nombres binaires relativement courts. Si l'on a affaire à des nombres binaires beaucoup plus longs, ayant par exemple plusieurs centaines d'éléments binaires, on pourra vérifier que l'obtention d'un tableau similaire au tableau 4, c'est-à-dire d'un tableau dans lequel chaque colonne comporte au maximum un seul élément binaire "1", peut nécessiter un grand nombre de cycles de pondérations et de comptages d'éléments "1", alors que l'obtention d'un tableau similaire au tableau 3, c'est-à-dire d'un tableau dans lequel chaque colonne comporte au maximum deux éléments binaires, est relativement rapide.

A partir du tableau similaire au tableau 3, il n'y a plus qu'à effecteur l'addition de deux nombres binaires, et même si ces deux nombres binaires sont très longs, les additionneurs habituellement connus sont suffisamment rapides pour la plupart des applications.

Par connséquent, grâce au procédé de traitement exposé ci-dessus, on peut effectuer la convolution d'un grand nombre de valeurs discrètes retardées très longues en un temps relativement très court.

Tous les circuits décrits ci-dessus peuvent être partiellement ou totalement intégrés, et on peut regrouper sur un même circuit intégré des blocs de traitement dans un ordre différent de celui représenté sur les figures.

Le dispositif représenté sur la figure 1 peut également effectuer des additions ou des multiplications. Pour effecteur une addition de plusieurs nombres, on peut par exemple envoyer sur les entrées d'adressage de chaque mémoire ou groupe de mémoires les éléments binaires de même poids de tous les nombres considérés, et l'opération effectuée par l'étage 2 revient à déterminer le nombre de "1" d'entrée, les coefficients $A_1$ à $A_n$ étant rendus égaux à 1.

Pour effectuer une multiplication d'un terme tel que $(a^{m-1}, a^{m-2}, \ldots a^1, a^0)$ pour un autre terme tel que $(b^{p-1}, b^{p-2} \ldots b^1\ b^0)$, on peut par exemple réaliser l'étage 2 avec $m$ mémoires affectées chacune à un des $m$ éléments binaires $a^{m-1}$, à $a^0$ et programmer chacune des mémoires pour fournir en sortie le total de "1" dudit autre terme $(b^{p-1} \ldots b^0)$ présents sur ses entrées, chacune de ces mémoires étant validée par l'élément binaire $a$ correspondant lorsque celui-ci est égal à "1".

Au lieu d'utiliser à chaque fois une mémoire morte, on peut soit utiliser un ensemble de plusieurs mémoires mortes commutables, soit utiliser des mémoires vives, ce qui est intéressant lorsque les coefficients mémorisés peuvent varier, comme c'est par exemple le cas pour des filtres numériques autoadaptatifs.

## Revendications

1. Dispositif opérateur numérique rapide destiné à effectuer une opération sur au moins deux termes, et comportant plusieurs mémoires de mémorisation de combinaisons d'un terme opératoire caractérisé par le fait qu'il comporte, à la sortie d'un premier étage (1) de registres d'entrée sur lesquels se présentent simultanément en parallèle tous les éléments binaires d'un premier terme de l'operation à effectuer, le premier terme étant un ensemble de n ($n \geq 1$) suites d'éléments binaires ponderés de poids 0 à $(m-1)$ representant chacune une valeur discrète, un étage de traitement opératoire (2) comportant plusieurs groupes de mémoires ($M_1^0$ à $M_k^0$, ... $M_1^{m-1}$ à $M_k^{m-1}$) comportant chacun une ou plusieurs mémoires, dans chacun desquels sont mémorisées, de façon connue en soi, toutes les combinaisons opératoires du second terme de l'opération a effectuer, les entrées de chaque groupe de mémoires (e.g. $M^{m-1}$) étant reliées aux sorties de tous les registres d'entrée auxquelles apparaissent les éléments binaires d'un même poids donné (e.g. $m-1$), l'étage de traitement opératoire étant suivi d'un second étage (3) de registres à entrées et sorties parallèles, ces registres étant répartis en groupes correspondant aux groupes de mémoires, les entrées de ces registres étant reliées aux sorties des mémoires de leur groupe, et leurs sorties étant pondérées, c'est-à-dire que leur poids propre (0 à $p-1$) est augmenté du poids des éléments binaires du premier terme que reçoit leur groupe (0 à $m-1$), les sorties des registres de ce seond étage (3) étant reliées à un premier étage de sommation pondérée (4, 5) comportant un étage de blocs de détermination de nombre "1" (4) et un troisième étage de registres (5), les blocs étant affectés chacun d'un poids binaire depuis de poids zéro jusqu'à un poids maximal ($m+p-2$) égal au poids maximal des sorties pondérées des registres du second étage de registres, les entrées de chaque bloc de poids donné étant reliées à toutes les sorties de même poids des registres du second étage de registres, les registres du troisième étage de registres étant affectés chacun à un bloc de détermination, et leurs sorties étant pondérées, c'est-à-dire que leur poids propre est augmenté du poids du bloc correspondant, ce premier étage de sommation pondérée étant suivi d'un ou de plusieurs autres étages de sommation pondérée similaires, dont les liaisons sont effectuées de mainère similaire, le nombre de ces étages de sommation pondérée étant tel quel dans le dernier d'entre eux chaque bloc de détermination a au maximum deux sorties, les sorties des registres de ce dernier étage de sommation pondérée étant reliées à des entrées correspondantes d'un additionneur rapide (6).

2. Dispositif selon la revendication 1, caractérisé par le fait que les mémoires de l'étage de traitement opératoire sont des mémoires mortes.

3. Dispositif selon la revendication 1, caractérisé par le fait que les mémoires de l'étage de traitement opératoire sont des mémoires vives.

4. Dispositif selon la revendication 2, caractérisé par le fait que les mémoires sont constituées par plusieurs ensembles commutables de mémoires mortes.

5. Dispositif selon l'une quelconque des revendications précédentes, l'opération à effectuer étant une convolution, caractérisé par le fait que le premier terme comporte plusieurs valeurs discrètes retardées ($n > 1$) et que l'on mémorise dans chaque groupe de mémoires les différentes combinaisons possibles de sommations de coefficients.

6. Dispositif selon l'une quelconque des revendications précédentes, l'opération à effectuer étant une addition de plusieurs nombres, caractérisé par le fait que le premier terme comporte plusieurs valeurs discrètes, chacune representant un des nombres, et que l'on mémorise dans chaque groupe de mémoires les différentes combinaisons possible de sommes d'éléments binaires de même poids.

7. Dispositif selon l'une quelconque des revendications 1 à 5, l'opération à effectuer étant une multiplication d'un premier nombre par un second terme ou nombre, caractérisé par le fait que le premier terme est le premier nombre et que l'on affecte chacune des mémoires à l'un des éléments binaires du premier terme de la multiplication, que l'on programme chacune des mémoires pour fournir en sortie le total de "1" du second terme présent sur ses entrées, chacune de ces mémoires étant validée par l'élément binaire correspondant du premier terme lorsque celui-ci est égal à "1".

## Patentansprüche

1. Schnelle digitale Operatorvorrichtung, die zur Durchführung einer Operation an wenigstens zwei Termem bestimmt ist und mehrere Speicher zum Speichern von Kombinationen eines Operationsterms enthält, dadurch gekennzeichnet, daß sie am Ausgang einer ersten Stufe (1) von Eingangsregistern, an denen gleichzeitig alle Binärelemente eines ersten Terms der durchzuführenden Operation parallel auftreten, wobei der erste Term eine Gruppe von n ($n \geq 1$) Folgen von gewichteten Binärelementen der Wertigkeiten 0 bis ($m-1$) ist, die jeweils einen diskreten Wert darstellen, eine Operations-Vererbeitungsstufe (2) umfaßt, welche mehrere Gruppen von Speichern ($M_1^0$ bis $M_K^0$, ... $M_1^{m-1}$ bis $M_K^{m-1}$) umfaßt, die jeweils einen oder mehrere Speicher enthalten, worin jeweils in an sich bekannter Weise alle Operationskombinationen des zweiten Terms der durchzuführenden Operation gespeichert sind, wobei die Eingänge jeder Gruppe von Speichern (z.B. $M^{m-1}$) mit den Ausgängen aller Eingangsregister verbunden sind, an denen die Binärelemente derselben gegebenen Wertigkeit (z.B. $m-1$) erscheinen, wobei auf die Operations-Verarbeitungsstufe eine zweite Stufe (3) von Registern mit parallelen Eingängen und Ausgängen folgt, wobei diese Register in Gruppen unterteilt sind, welche den Speichergruppen entsprechen, wobei die Eingänge dieser Register mit den Ausgängen der Speicher ihrer Gruppe verbunden sind und ihre Ausgänge gewichtet sind, d.h. ihre eigene Wertigkeit (0 bis $p-1$) um die Wertigkeit der Binärelemente des ersten Terms erhöht wird, die ihre Gruppe (0 bis $m-1$) empfängt, wobei die Ausgänge der Register dieser zweiten Stufe (3) mit einer ersten Stufe (4, 5) zur gewichteten Summation verbunden sind, welche eine Stufe von Blöcken zur Bestimmung der Anzahl von "1" (4) sowie eine dritte Stufe von Registern (5) enthält, wobei die Blöcke jeweils einer binären Wertigkeit von der Wertigkeit 0 bis zu einer maximalen Wertigkeit ($m+p-2$) zugeordnet sind, die gleich der maximalen Wertigkeit der gewichteten Ausgänge der Register der zweiten Stufe von Registern ist, wobei die Eingänge jedes Blockes gegebener Wertigkeit mit allen Ausgängen gleicher Wertigkeit der Register der zweiten Stufe von Registern verbunden sind, die Register der dritten Stufe von Registern jeweils einem Bestimmungsblock zugeordnet sind und ihre Ausgänge gewichtet sind, d.h. ihre Eigene Wertigkeit um die Wertigkeit des entsprechenden Blocks erhöht ist, wobei auf diese erste Stufe zur gewichteten Summation eine oder mehrere weitere gleich Stufen zur gewichteten Summation folgen, deren Verbindungen in gleicher Weise ausgeführt sind, wobei die Anzahl dieser Stufen zur gewichteten Summation derart ist, daß in der letzten von ihnen jeder Bestimmungsblock höchstens zwei Ausgänge aufweist, und wobei die Ausgänge der Register dieser letzten Stufe zur gewichteten Summation mit entsprechenden Eingängen eines schnellen Addierers (6) verbunden sind.

2. Vorrichtung nach Anspruch 1, dadurch gekennzeichnet, daß die Speicher der Operations-Verarbeitungsstufe Festwertspeicher sind.

3. Vorrichtung nach Anspruch 1, dadurch gekennzeichnet, daß die Speicher der Operations-Verarbeitungsstufe Arbeitsspeicher sind.

4. Vorrichtung nach Anspruch 2, dadurch gekennzeichnet, daß die Speicher durch mehrere umschaltbare Gruppen von Festwertspeichern gebildet sind.

5. Vorrichtung nach einem der vorstehenden Ansprüche, bei welcher die durchzuführende Operation eine Faltung ist, dadurch gekennzeichnet, daß der erste Term mehrere diskrete verzögerte Werte ($n>1$) umfaßt und daß in jeder Gruppe von Speichern die verschiedenen möglichen Koeffizienten-Summationsmöglichkeiten gespeichert werden.

6. Vorrichtung nach einem der vorstehenden Ansprüche, bei welcher die durchzuführende Operation eine Addition von mehreren Zahlen ist, dadurch gekennzeichnet, daß der erste Term mehrere diskrete Werte umfaßt, die jeweils eine der Zahlen darstellen, und daß in jeder Gruppe von Speichern die verschiedenen möglichen Kombinationen von Summen der Binärelemente gleicher Wertigkeit gespeichert werden.

7. Vorrichtung nach einem der Ansprüche 1 bis 5, bei welcher die durchzuführende Operation eine Multiplikation einer ersten Zahl mit einem zweiten Term bzw. einer zweiten Zahl ist, dadurch gekennzeichnet, daß der erste Term die erste Zahl ist und daß jeder der Speicher einem der Binärelemente des ersten Terms der Multiplikation zugeordnet wird, daß jeder der Speicher so programmiert wird, daß er ausgangsseitig die Gesamtzahl von "1" des zweiten Terms liefert, die an seinen Eingängen vorhanden sind, wobei jeder dieser Speicher durch das entsprechende Binärelement des ersten Terms freigegeben wird, wenn dieses gleich "1" ist.

**Claims**

1. Fast digital operator device for performing an operation on at least two terms and comprising a plurality of memories for storing combinations of an operational term, characterized by the fact that it comprises, at the output of a first stage (1) of input registers whereat all the binary elements of a first term of the operation to be performed are presented simultaneously in parallel, the first term being a set of n ($n \geqq 1$) sequences of weighted binary elements of the weights 0 to ($m-1$) each representing one discrete value, an operational processing stage (2) comprising a plurality of memory groups ($M_1^0$ to $M_K^0$, ... $M_1^{m-1}$ to $M_K^{m-1}$) each comprising one or a plurality of memories each storing in a manner known per se all the operational combinations of the second term of the operation to be performed, the inputs of each group of memories (e.g. $M^{m-1}$) being connected to the outputs of all of the input registers where the binary elements of the same given weight (e.g. $m-1$) appear, the operational processing stage being followed by a second stage (3) with parallel inputs and outputs, these registers being distributed into groups corresponding to the groups of memories, the inputs of these registers being connected to the outputs of the memories of their group, and their outputs being weighted, i.e. their intrinsic weight (0 to $p-1$) is increased by the weight of the binary elements of the first term received by their group (0 to $m-1$), the outputs of the registers of this second stage (3) being connected to a first weighted summation stage (4, 5) comprising a stage of blocks for the determination of the number of "ones" (4) and a third stage of registers (5), the blocks being each associated with a binary weight from the weight zero to a maximum weight ($m+p-2$) equal to the maximum weight of the weighted outputs of the registers of the second stage of registers, the inputs of each block of a given weight being connected to all of the outputs of the same weight of the registers of the second stage of registers, the registers of the third stage of registers being each associated with a determination block, and their outputs being weighted, i.e. their intrinsic weight is increased by the weight of the corresponding block, this first weighted summation stage being followed by one or a plurality of further similar weighted summation stages the connections of which are established in the same manner, the number of these weighted summation stages being such that in the last of them each determination block has a maximum of two outputs, the outputs of the registers of this last weighted summation stage being connected to corresponding inputs of a fast adder (6).

2. Device according to claim 1, characterized by the fact that the memories of the operational processing stage are read only memories.

3. Device according to claim 1, characterized by the fact that the memories of the operational processing stage are random access memories.

4. Device according to claim 2, characterized by the fact that the memories are formed of a plurality of switchable sets of read only memories.

5. Device according to any of the preceding claims, the operation to be performed being a convolution, characterized by the fact that the first term comprises a plurality of discrete delayed values ($n > 1$) and that in each group of memories the different possible combinations of summations of coefficients are stored.

6. Device according to any of the preceding claims, the operation to be performed being an addition of a plurality of numbers, characterized by the fact that the first term comprises a plurality of discrete values each representing one of the numbers, and in that in each group of memories the different possible combinations of sums of binary elements of the same weight are stored.

7. Device according to any of claims 1 to 5, the operation to be performed being a multiplication of a first number by a second term, or number, characterized by the fact that the first term is the first number and that each of the memories is associated with one of the binary elements of the first term of the multiplication, that each of the memories is programmed to provide on its output the total number of "ones" of the second term present at its inputs, each of these memories being enabled by the binary element corresponding to the first term if this is equal to "1".

Fig. 1

Fig.2